# EUROPEAN PATENT APPLICATION

(11) **EP 1 561 842 A2**
(43) Date of publication of application: **10.08.2005**
(21) Application number: 04258027.4
(22) Date of filing: 22.12.2004
(51) Int. Cl.: C23C 16/455, C23C 16/44

(54) **Apparatus and method for atomic layer deposition**

(30) Priority: 31.12.2003 US 749961
(71) Applicant: THE BOC GROUP, INC., Murray Hill, New Providence, New Jersey 07974 (US)
(72) Inventor: Jansen, Frank, San Jose, California 95132 (US)
(74) Representative: Booth, Andrew Steven

(57) **Abstract**

A trap with a residence time at least equal to one complete cycle time of an atomic layer deposition ( ALD ) process traps the gaseous effluent from a reaction chamber and reaction products before the effluent can enter a backing pump. The trap may be connected directly to the reaction chamber or indirectly through a process pump. The trap is advantageously used in atomic layer deposition processes.

## Description

This invention relates generally to apparatus and methods for the deposition of thin films and particularly to apparatus and methods for the deposition method referred to as atomic layer deposition.

Many aspects of modern technology require the deposition of thin films on a substrate. For example, integrated circuit technology requires the deposition of dielectrics, metals and semiconducting films. Examples of dielectrics include silicon oxide and silicon nitride used in gates in field effect transistors as well as tantalum oxide used in capacitors for dynamic random access memories ( DRAMs ). Examples of conducting materials include Al and Cu which are used to make electrical connections between circuit elements as well as TiN and TaN which are used as barrier layers between, for example, silicon oxide and copper. The deposited layers may be single crystal, polycrystalline, or amorphous depending on factors which include the material, the deposition conditions, and the substrate on which films are deposited.

A variety of deposition techniques has been developed. The choice of a particular technique is determined by considerations including the material deposited and the underlying material or substrate. For example, physical vapor deposition, such as sputtering, was long used for deposition of aluminum and other materials. In this method, a particle, for example, an ion, strikes a target and momentum transfer dislodges material from the target so that it travels to the substrate. Although adequate for many applications and materials, this deposition technique became difficult to use with, for example, tungsten, when dimensions became approximately .5 microns or smaller. Deposition of sufficiently conformal coatings proved difficult and filling of small contact holes became nearly impossible. A conformal coating is obtained when the deposited material grows uniformly in all directions on a non-planar substrate; that is, the coating has a uniform thickness over the surface irregularities. Another deposition technique is chemical vapor deposition (CVD). One or more precursor gases, possibly together with an inert carrier gas, flow into a reaction chamber containing the substrate and thermally decompose to form a thin film or layer of the desired material. The reaction is primarily on the substrate although there may also be a small amount of vapor phase reaction. Unreacted precursor gases are continuously removed from the reaction chamber. This technique is used with many materials including silicon, silicon oxide, and tungsten. A typical CVD process requires the substrate to be heated to high temperatures; often much higher than 400 degrees centigrade. These high temperatures are increasingly incompatible with the maximum allowed temperatures of new device structures.

As integrated circuit dimensions have decreased further into the submicron region, use of the above described deposition techniques to obtain layers with both the desired thicknesses and compositions has become more difficult, and additional deposition techniques have been developed. One such technique is commonly referred to as atomic layer deposition (ALD). A first precursor gas is introduced into the reaction chamber where it adsorbs and forms a monolayer on the substrate. Unreacted precursor gas is purged from the reaction chamber, and a second precursor gas is introduced into the chamber. A second monolayer is formed. The process conditions have been adjusted in such a way that the first and the second monolayer chemically react with each other. Again, the unreacted precursor gas, together with any reaction products, are purged from the chamber. Both monolayers are formed in a self-limiting manner; that is, after a single layer forms on the exposed surface, the adsorption terminates. More than two precursor gases may be used, and the precursor gases may be introduced together with a carrier gas. Process conditions favorable for the promotion of reactions between the two monolayers include the choice of gases, the substrate temperature or any other means of gas activation such as gas radicalization with a plasma. The growth rate of the film may be relatively slow, but with the ALD process, precise control over layer thicknesses and film conformality as well as film compositions is obtained. One obvious problem with ALD is that the method involves the use of mutually reactive gases. Separating the introduction in time of the precursor gases reduces, and perhaps practically eliminates, the possibility of these gas phase reactions.

Successful implementation of ALD requires purging of the precursor gases from the reaction chamber, and there are now numerous references in the literature to apparatus and methods for purging the reaction chamber and protecting the pumps in the exhaust system from the detrimental effects of the precursor gases and their reaction products. Purging of the chamber is also frequently required for etching processes as well as deposition processes. Several of these references will now be briefly described.

United States Patent 4,647,338 issued on March 3, 1987 to Visser describes a deposition technique using an inert gas together with the precursor ( termed "reaction" by Visser) gas. A cooled trap is positioned between a pump and the reaction chamber, and the unreacted precursor or other gas condenses in the cooled trap. The condensed gas retained in the cooled trap may be very corrosive and would thus damage the pump. To reduce the amount of inert gas required in the reaction chamber, another inert gas is fed into the system between the cooled trap and the pump in an amount equal to the condensed gas thereby optimizing the process according to Visser. Visser explicitly describes etching processes.

United States Patent 5,250,323 issued on October 5, 1993 to Miyazaki describes chemical vapor deposition with an exhaust system that includes a trap. Miyazaki recognized that some source gas might remain in the flow rate controllers, used individually for the precursor and inert gases, before the reaction chamber and should be removed before another gas is introduced into the reaction chamber. Hence, Miyazaki teaches the use of a trap between the flow rate controllers and the exhaust.

United States Patent 5,704,214 issued on January 6, 1998 to Fujikawa, Murikami and Hatano ( Fujikawa ) shows a cold trap, between the reaction chamber and the exhaust, which freezes gases that Fujikawa terms "tramp" materials. The term "tramp" includes unreacted gases as well as reaction products. Fujikawa recognized that the tramp materials might condense in the pump and thus damage the pump or even clog the pipe between the reaction chamber and the pump. There are two pumps depicted. The first is termed a precision or drag pump, and the second is termed a rough or dry pump. The cold trap precedes both pumps in the exhaust system.

United States Patent 6,506,352 issued on January 14, 2003 to Lindfors and Hyvarinen ( Lindfors ) uses a large surface area trap to capture unreacted precursor gases prior to the point at which they would enter the pump. The trap is called a secondary reaction space or reactant trap and has a large surface area such as that provided by a porous material. The secondary reaction space is maintained under conditions that are substantially the same as those in the primary reaction space. The similar conditions and large surface area result in deposition of the gases in the reactant trap. Unreacted precursor materials and reaction products are thus deposited in the porous material trap and do not reach the pump. However, the presence of the porous material reduces the conductance of the trap as compared to the conductance of the trap without the porous material. Lindfors explicitly mentions use of ALD with his apparatus. United States Patent Application Publication 2002/0187084 published on December 12, 2002 is a continuation of the application that resulted in the previous patent.

In a first aspect, the present invention provides deposition apparatus comprising a reaction chamber, at least one precursor gas source for supplying at least one precursor gas to the reaction chamber, a purge gas source for supplying a purge gas to the reaction chamber, a valve arrangement for controlling the supply of each gas to the reaction chamber to define a deposition cycle, and a trap having an inlet connected to the reaction chamber and a residence time at least equal to one deposition cycle.

A preferred embodiment provides deposition apparatus, such as atomic layer vapor deposition apparatus or chemical vapor deposition apparatus, having first and second precursor gas sources, first and second valves connected to said first and second precursor gas sources; a purge gas source, said purge gas source having a third valve, said gas sources operating sequentially to define a deposition cycle; a reaction chamber, said reaction chamber being connected to said first, said second, and said third valves; a trap connected to said reaction chamber; said trap having an inlet and an outlet, said inlet being connected to said reaction chamber, said trap having a residence time at least equal to the deposition cycle; and a backing pump connected to said outlet of said trap and to exhaust.

A second aspect of the present invention provides a method of deposition comprising the steps of sequentially flowing first and second precursor gases into a reaction chamber; flowing a purge gas after each of said precursor gases thereby defining a deposition cycle; and removing the gaseous effluent from said reaction chamber, said removing including trapping the gaseous effluent in a trap, said gaseous effluent having a residence time in said trap at least equal to said deposition cycle.

Preferred features of the present invention will now be described, by way of example only, with reference to the accompanying drawings, in which:
Figure 1 illustrates the atomic layer deposition process;
Figure 2 is a schematic representation of an embodiment of deposition apparatus; and
Figure 3 is a schematic representation of an embodiment of the exhaust section of the deposition apparatus.

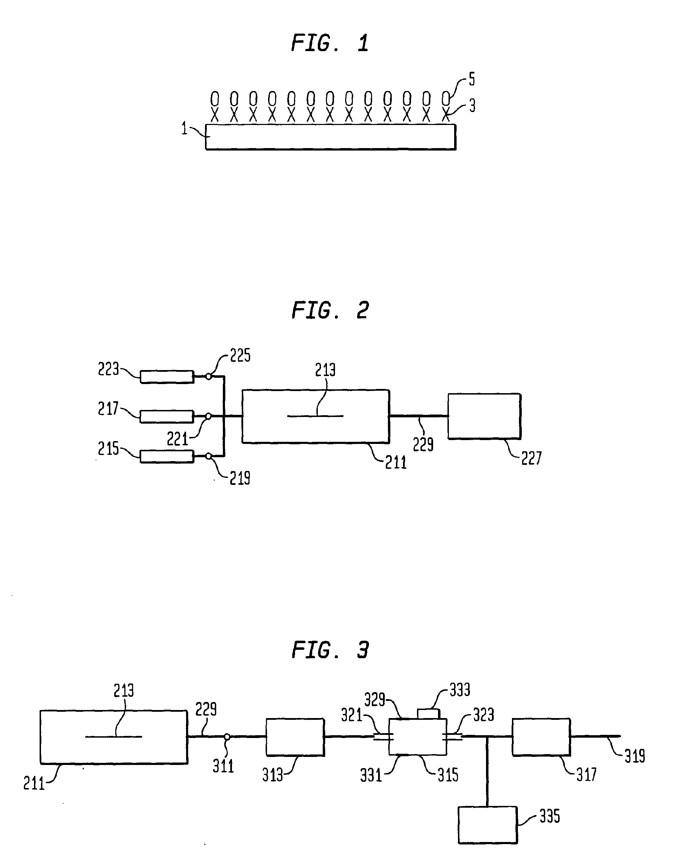

Salient features of an atomic layer deposition process will be briefly described by reference to FIG. 1. Shown in FIG. 1 are substrate 1 on which are deposited monolayers of a first species 3 and a second species 5 which are indicated by x and o, respectively. During the growth process, the substrate 1 is located in a reaction chamber (not shown), typically heated, and a first precursor gas containing species 3 is introduced into the chamber. A monolayer of the first precursor gas is absorbed on the surface of the substrate 1. The excess amount of the first precursor gas; that is, the material not absorbed, is then purged from the chamber, and a second precursor gas containing species 5 is introduced into the chamber. A monolayer of the second precursor gas is absorbed on the substrate 1. A reaction between the absorbed first and second precursors leaves only the first and second species 3 and 5, respectively, on substrate 1. The chamber is now purged and the unreacted portion of the second precursor gas together with the reaction products are removed from the reaction chamber

Variations of the process described are possible. For example, more than two precursor gases could be used. Additionally, the second precursor gas could be activated by a plasma to effect a chemical treatment of the first monolayer. Numerous materials, for example, many oxides and nitrides, may be deposited with this process for the applications previously described as well as other applications. The process of sequentially admitting precursor gases into the reaction chamber, with intermediate purge gas pulses, is then repeated to grow as many additional layers as desired.

An embodiment of apparatus according to this invention is schematically depicted in FIG. 2. Reaction chamber 211 contains substrate 213. The substrate support is not shown. First and second precursor sources 215 and 217, respectively; are connected to reaction chamber 211 through valves 219 and 221, respectively, and appropriate pipes. Purge gas source 223 is connected to reaction chamber 211 through valve 225 and an appropriate pipe. The purge gas is an inert gas. Exhaust system 227 removes the unwanted gases; that is, the gaseous effluent, from the reaction chamber 211 and will be described in detail with respect to FIG. 3. Pipe 229 connects reaction chamber 211 and exhaust system 227. The gaseous effluent includes, for example, the unreacted precursor gases and the reaction products. The reaction chamber may be heated although the heating elements are not depicted and are not always required.

Operation of the apparatus will now be described. The first precursor gas is allowed into the reaction chamber in a predetermined quantity and for a predetermined time followed by the purge gas in a predetermined quantity for a predetermined amount of time. The second precursor gas is then allowed into the reaction chamber in a predetermined quantity and for a predetermined time and is also followed by the purge gas in a predetermined quantity for a predetermined amount of time; that is, the precursor gases are introduced sequentially with the purge gas introduced between the pulses of the precursor gases. The sequence of first precursor gas, purge gas, second precursor gas, and purge gas forms one deposition cycle. The gas flows are controlled by the valves associated with the individual gases. As will be appreciated, the valves must be operated rapidly to increase apparatus efficiency. As will also be appreciated, the exhaust system must operate efficiently not only for apparatus efficiency but to insure the quality of the deposited material.

Appropriate precursor gases will be readily selected by those skilled in the art after consideration of parameters such as the material desired and the underlying substrate. The purge gas is often chosen to be an inert gas such as argon. Nitrogen may sometimes be used.

The exhaust system 227 is depicted in FIG. 3. Depicted are reaction chamber 211, gate valve 311, process pump 313, trap 315, and backing pump 317. The gate valve 311 is between process pump 313 and the reaction chamber 211. Trap 315 is positioned between process pump 313 and backing pump 317. Trap 315 has inlet 321 and outlet 323. The effluent from backing pump 317 goes to the main exhaust 319. Additional elements, such as local scrubbers, may be present as desired but their depiction is not required for an explanation of the invention. All elements except the reaction chamber 211 are included in the exhaust system 227 shown in FIG. 2. The apparatus, except for trap 315, will be readily fabricated by those skilled in the art and additional explanation is not required for these elements.

The following elements may be present and will be described in detail later. Electrode 329 is in trap 315 and ground connection 331 to made to trap 315. Heater 333 may be used to heat trap 315. Surge flow suppresser 335 is connected to outlet 323.

The design and operation of trap 315 requires additional explanation for an understanding of the invention. It is designed to insure that gas molecules have a long residence time in the trap. The longer the residence time for the gas molecules, the greater the likelihood of gas phase reactions between the first and second precursor gases which reduce the possibility of the gases reacting with each other after entering the backing pump where they might damage the pump or interfere with the proper operation of the pumping mechanism. The detailed design of trap 315, including the meaning of long residence time, will be better understood from consideration of the following.

The residence time of a gas molecule in a volume V flowing at a flow rate Q in a gas stream of pressure P is PV/Q. Thus, low pressure and small volume, such as in the reaction chamber, results in a short residence time and low likelihood of gas phase reaction. The pressure increases downstream from the reaction chamber where most of the pressure increase occurs in the pumping system over which the pressure differential is nearly one atmosphere. As the pressure increases, there is the increased likelihood of gas phase reactions and subsequent powder formation occurring to the detriment of pump efficiency. Trap 315 is constructed to insure that the reactive precursor gases are present in the trap 315 at the same time; that is, the first and second precursor gases are present simultaneously and thus react to form a powder that remains in the trap 315. Trap 315 is constructed with a volume V to have a residence time at least equal to one complete cycle of the ALD process. It is preferred that the residence time be longer than one complete cycle of the ALD process.

In another embodiment, the process pump 313 is omitted and the trap 315 is connected to reaction chamber 211. Although this configuration has advantages with respect to the prior art, it is less preferred than is the embodiment with the process pump 313. The following explanation will be helpful in understanding why this embodiment is less preferred. The process pump 313 insures that trap 315 is placed in a relatively high pressure environment. The trap can thus be physically smaller than it would be in a low pressure environment. It also increases the likelihood of gas phase reactions prior to the backup pump. In the high pressure region in trap 315, the gas density is relatively high and the molecular mean free path is short thereby increasing the likelihood of gas phase reactions prior to exiting the trap. Additionally, the low gas velocities decrease the possibility that the powder will be entrained in the gas as it exits the trap.

The conductance of the trap should not decrease during operation. This can be accomplished by placing the inlet 321 and outlet 323 at the top of the trap as shown; that is, most of the volume of the trap is below the inlet and outlet. Thus, powders and solid deposits remain in the trap without significantly reducing its conductance. The inverted configuration; that is, the configuration with both inlet 321 and outlet 323 at the bottom; or a partially inverted configuration; that is, a configuration with either inlet 321 or outlet 323 at the bottom, will have a decreasing conductance as powder accumulates and begins to obstruct either or both the inlet 321 and outlet 323.

It is often desirable to promote the reaction of the precursor gases in the long residence time trap 315 by creating energetically favorable conditions for the reaction to occur. For example, in the case that the two reactant gases are WF₆ and H₂, the reaction will proceed at room temperature at a low rate. To ensure that the reaction occurs in the trap 315, trap 315 or a portion thereof may be heated with heater 333 to a sufficiently high temperature. This temperature will be readily determined by those skilled in the art. Additionally, a plasma may be created in trap 315 by applying an appropriate voltage between electrode 329 and ground connection 331.

Surge flow suppresser 335 between trap 315 and pump 317 avoids pressure transients and the resulting high gas flows that would entrain powder already in trap 315. These surge flow suppressors are well to those skilled in the art and need not be described in more detail.

Although the invention has been specifically described with respect to atomic layer deposition, it should be understood that the apparatus may also be used for other chemical vapor deposition processes in which the precursor gases are sequentially admitted and spaced from each other by an inert gas pulse. It is also to be understood that the removing step involves the use of the trap, and other steps may be present. It is also contemplated that advantages may result from use of the trap even absent a pump.

In summary, a trap with a residence time at least equal to one complete cycle time of an atomic layer deposition (ALD) process traps the gaseous effluent from a reaction chamber and reaction products before the effluent can enter a backing pump. The trap may be connected directly to the reaction chamber or indirectly through a process pump. The trap is advantageously used in atomic layer deposition processes.

## Claims

1. Deposition apparatus comprising a reaction chamber (211), at least one precursor gas source (215; 217) for supplying at least one precursor gas to the reaction chamber, a purge gas source (223) for supplying a purge gas to the reaction chamber, a valve arrangement (219, 221, 225) for controlling the supply of each gas to the reaction chamber to define a deposition cycle, and a trap (315) having an inlet connected to the reaction chamber and a residence time at least equal to one deposition cycle.

2. Deposition apparatus according to Claim 1, wherein the deposition cycle is defined by the sequential supply to the chamber of each precursor gas followed by a supply of purge gas after each respective precursor gas.

3. Deposition apparatus according to Claim1 or Claim 2, comprising a backing pump (317) connected to an outlet (323) of the trap (315).

4. Deposition apparatus according to any preceding claim, wherein the inlet of the trap and an outlet from the trap are located towards or at the top of said trap (315).

5. Deposition apparatus according to any preceding claim, comprising a process pump (313) connected between said inlet (321) of said trap (315) and said reaction chamber (211).

6. Deposition apparatus according to any preceding claim, wherein said residence time is greater than said deposition cycle.

7. Deposition apparatus according to any preceding claim, wherein said trap (315) includes a heater (333).

8. Deposition apparatus according to any preceding claim, wherein said trap (315) includes an electrode (329) and a ground connection (331) to said trap (315).

9. Deposition apparatus according to any preceding claim, comprising a surge flow suppresser (335) connected to an outlet (323) of said trap (315).

10. Deposition apparatus according to any preceding claim, wherein said apparatus is one of a chemical vapor deposition apparatus, and an atomic layer deposition apparatus.

11. A method of deposition comprising the steps of:
sequentially flowing first and second precursor gases into a reaction chamber;
flowing a purge gas into said reaction chamber after said first precursor gas and after said second precursor gas, the flowing of said precursor gases and said purge gas forming a deposition cycle; and
removing the gaseous effluent from said reaction chamber, said removing including trapping the gaseous effluent in a trap, said gaseous effluent having a residence time in said trap at least equal to said deposition cycle.

12. A method according to Claim 11 wherein the gaseous effluent is removed from the reaction chamber using a backing pump downstream from the trap.

13. A method according to Claim 11 or Claim 12, wherein the gaseous effluent is removed from the reaction chamber using a process pump upstream from the trap.

14. A method according to any of Claims 11 to 13, wherein said residence time is greater than said deposition cycle.
